# FASCICULE DE BREVET EUROPEEN

(11) **EP 3 195 917 B1**
(45) Date de publication et mention de la délivrance du brevet: **30.07.2025**
(21) Numéro de dépôt: 16204275.8
(22) Date de dépôt: 15.12.2016
(51) Int. Cl.: B01D 46/00, B01D 46/10, B01D 53/04, F04D 19/00, F04D 25/14

(54) **SYSTÈME DE FILTRATION D'AIR POUR ARMOIRE ÉLECTRIQUE**
SYSTEM ZUR LUFTFILTERUNG FÜR SCHALTSCHRANK
AIR FILTERING SYSTEM FOR AN ELECTRICAL ENCLOSURE

(30) Priorité: 22.01.2016 FR 1650521
(43) Date de publication de la demande: 26.07.2017
(73) Titulaire: Schneider Electric Industries SAS, 92500 Rueil-Malmaison (FR)
(72) Inventeur: LOPEZ, Josep, 38050 Grenoble Cedex 09 (FR); PERRIN, Alain, 38050 Grenoble Cedex 09 (FR)
(74) Mandataire: Schneider Electric

(56) Documents cités:
- EP-A1- 2 246 634
- WO-A1-2014/187903
- DE-A1- 19 949 934
- DE-A1- 2 831 167
- US-A1- 2009 323 281

## Description

### Domaine technique de l'invention

La présente invention se rapporte à un système de filtration d'air pour une enveloppe électrique.

### Etat de la technique

Pour des raisons d'efficacité énergétique, il est aujourd'hui nécessaire de tenir compte de l'énergie électrique consommée pour la dissipation thermique des appareils électriques logés dans une enveloppe électrique, telle que par exemple une armoire électrique. Pour cette dissipation thermique, l'enveloppe électrique comporte en général une entrée d'air sur laquelle est positionné un dispositif de ventilation destiné à favoriser l'injection de l'air dans l'enveloppe pour refroidir les appareils électriques et une sortie d'air pour évacuer l'air chaud en dehors de l'enveloppe. Pour éviter d'amener des poussières ou autres particules polluantes à l'intérieur de l'enveloppe, un filtre est positionné au niveau de l'entrée d'air de l'enveloppe. Ce filtre est par exemple composé d'un matériau alvéolaire chargé de capter les particules venant de l'extérieur lors de l'injection d'air dans l'enveloppe et ainsi de permettre l'injection d'un air « propre » dans l'enveloppe électrique. Pour assurer un refroidissement efficace des appareils électriques, le flux d'air injecté dans l'enveloppe doit toujours être suffisant.

Dans les installations récentes, pour améliorer la capacité de refroidissement des appareils, il est proposé d'augmenter le nombre de ventilateurs et d'étendre la surface active de filtration. Le flux d'air injecté dans l'armoire est donc plus important. Dans ce type d'installation, plusieurs cellules de ventilation, dotées chacune d'un ventilateur et d'un filtre, sont par exemple agencées de manière adjacente.

Avec une telle architecture de ventilation, tous les filtres sont donc utilisés en même temps. Ils peuvent donc s'user au même rythme ou avec des disparités, rendant ainsi la maintenance de l'architecture plus compliquée. Pour une telle architecture, différents scenarii de maintenance du système de filtration peuvent être mis en place, mais ceux-ci ne sont jamais totalement satisfaisants. Ces différents scénarii sont les suivants :
- Un opérateur pourra attendre que tous les filtres soient suffisamment usés pour tous les remplacer en même temps. Cependant, cela peut entraîner une baisse significative de la capacité de refroidissement de l'architecture si les filtres présentent une usure trop prononcée.
- Un opérateur pourra remplacer chaque filtre indépendamment en fonction de son niveau d'encrassement, mais cela oblige un contrôle régulier du niveau d'encrassement des filtres.
- Un opérateur pourra remplacer tous les filtres en même temps avant que ceux -ci ne soient trop usés. Cela engendre un coût plus important et nécessite tout de même des visites de contrôle régulières.

Il faut noter qu'en cas de baisse significative de la capacité de refroidissement liée à un encrassement trop prononcé des filtres, deux situations distinctes peuvent se présenter :
- Dans une première situation, le flux d'air injecté devient insuffisant et les appareils électriques auront alors tendance à s'échauffer, pouvant entraîner des dysfonctionnements, leur arrêt ou leur casse en cas de surchauffe.
- Dans une deuxième situation, le flux d'air nécessaire pour refroidir correctement les appareils électriques logés dans l'enveloppe est maintenu mais sollicite de manière accrue le dispositif de ventilation, ce qui à terme peut affecter sa durée de vie.

Il est donc nécessaire de tenir compte du niveau d'encrassement des filtres d'entrée d'air pour les nettoyer ou les remplacer au moment opportun, avant que l'une des deux situations décrites ci-dessus se produise.

La demande de brevet DE19949934A1 propose pour sa part une solution dans laquelle plusieurs éléments de filtration logés dans des compartiments indépendants. Les compartiments peuvent être activés de manière indépendante mais la solution proposée n'est cependant pas satisfaisante car elle ne permet pas de s'adapter simplement au niveau d'encrassement des éléments de filtration. Les demandes de brevet DE 28 31 167 A1, WO 2014/187903 A1 et WO 2014/187903 A1 proposent d'autres dispositifs de filtrage avec des compartiments.

Le but de l'invention est de proposer un système de filtration d'air pour enveloppe électrique qui permet de palier les inconvénients de l'état de la technique listés ci-dessus.

### Exposé de l'invention

**C**e but est atteint par un système de filtration d'air pour enveloppe électrique, selon la revendication 1.

Selon une particularité, chaque cellule de filtration Ci est agencée pour être activée par effet mécanique lorsque le flux d'air en entrée présente une pression qui devient supérieure à une valeur déterminée, ladite valeur déterminée étant dépendante dudit seuil de capacité de filtration des cellules C1 à Ci-1.

Selon une autre particularité, chaque cellule de filtration Ci comporte un clapet mobile entre une position ouverte et une position fermée, ledit clapet étant calibré pour se déplacer vers sa position ouverte lorsque la pression du flux d'air en entrée devient supérieure à ladite valeur déterminée.

Selon une autre particularité, le clapet est monté mobile en pivotement autour d'un axe.

Selon une autre particularité, chaque cellule comporte un verrou agencé pour verrouiller le clapet en position fermée.

Selon une première variante de réalisation, dans chaque cellule, l'élément de filtration est logé dans la cellule, en amont du clapet.

Selon une deuxième variante de réalisation, dans chaque cellule, l'élément de filtration est positionné en aval du clapet.

Avantageusement, chaque cellule de filtration peut par exemple comporter un capteur agencé pour prendre un premier état correspondant à l'état désactivé de la cellule de filtration ou un deuxième état correspondant à l'état activé de la cellule. Le système comporte alors par exemple une unité de traitement connectée à chaque capteur et agencée pour récupérer l'état de chaque capteur.

Avantageusement, l'unité de traitement comporte un module de calcul agencé pour calculer une durée s'écoulant entre deux activations successives de deux cellules de filtration.

Avantageusement, l'unité de traitement comporte un module de prédiction du moment de remplacement de l'élément de filtration à partir de la durée calculée par le module de calcul.

L'invention concerne également une enveloppe électrique destinée à loger des appareils électriques et comportant une entrée d'air, une sortie d'air, un dispositif de ventilation agencé pour favoriser l'injection d'air par l'entrée d'air de l'enveloppe et un système de filtration conforme à celui défini ci-dessus et positionné au niveau de l'entrée d'air, en amont du dispositif de ventilation par rapport au sens d'injection d'air dans l'enveloppe.

### Brève description des figures

D'autres caractéristiques et avantages vont apparaître dans la description détaillée qui suit faite en regard des dessins annexés dans lesquels :
- la figure 1 représente de manière schématique et en vue de côté, une enveloppe électrique sur laquelle est positionné le système de filtration de l'invention,
- les figures 2A et 2B représentent de manière schématique le système de filtration d'air de l'invention, représenté selon deux variantes de réalisation distinctes,
- les figures 3A à 3E illustrent le principe de fonctionnement du système de filtration d'air de l'invention,
- la figure 4 représente une variante de réalisation avantageuse du système de filtration d'air de l'invention.

### Description détaillée d'au moins un mode de réalisation

L'invention a trait à un système de filtration 2 employé pour filtrer l'air injecté à l'intérieur d'une enveloppe électrique pour refroidir les appareils électriques installés dans l'enveloppe.

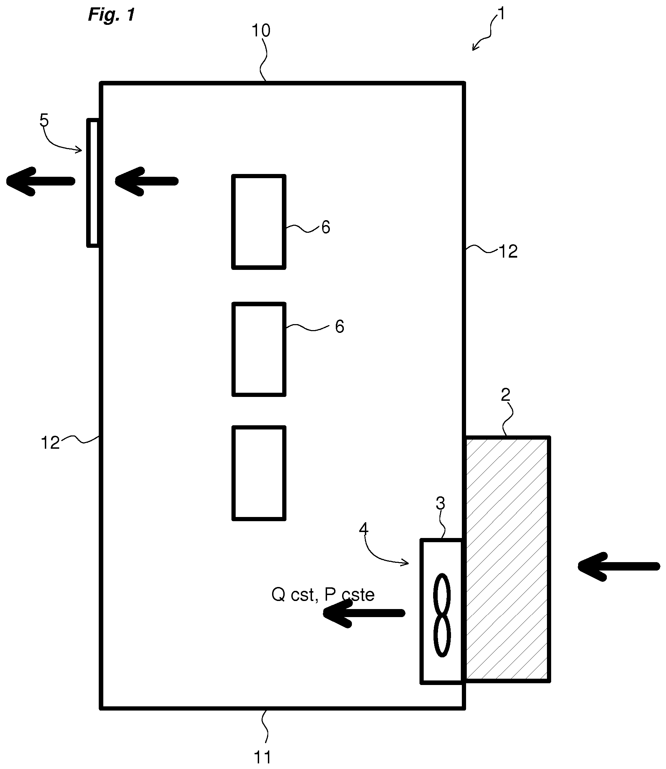

En référence à la figure 1, nous prenons comme exemple une enveloppe électrique 1 qui présente une forme parallélépipédique comprenant une paroi supérieure 10, une paroi inférieure 11 et quatre parois latérales 12 opposées deux à deux. Bien entendu, le système de filtration de l'invention pourra s'adapter à tous types, toutes formes et tailles d'enveloppes électriques.

L'enveloppe électrique 1 est destinée à loger des appareils électriques 6, par exemple fixés sur des rails, et comporte une entrée d'air 4 par laquelle est injecté de l'air à l'intérieur de l'enveloppe électrique 1 et une sortie d'air 5 pour évacuer l'air chaud vers l'extérieur de l'enveloppe électrique 1.

Un dispositif de ventilation 3 est positionné sur l'entrée d'air 4 de l'enveloppe. Lorsqu'il est activé, il permet de générer un flux d'air qui est injecté à l'intérieur de l'enveloppe 1.

Le système de filtration 2 de l'invention est positionné sur l'entrée d'air 4, en amont du dispositif de ventilation 3, par rapport au sens d'injection d'air dans l'enveloppe. Le système de filtration est destiné à filtrer le flux d'air injecté via l'entrée d'air dans l'enveloppe grâce au dispositif de ventilation 3. La sortie du système de filtration est connectée sur l'entrée d'air de l'enveloppe 1.

Dans la suite de la description et sur les figures annexées, on considérera que l'air est injecté dans l'enveloppe, donc en sortie du système de filtration 2, suivant un flux de débit Q constant (indiqué « Q cst » sur les figures) et à une pression P constante (indiquée « P cste » sur les figures).

Sur la figure 1, l'enveloppe électrique munie du système de filtration de l'invention est représentée en vue de côté et présente, de manière non limitative, l'agencement suivant :
- L'entrée d'air et la sortie d'air sont représentées sur deux parois latérales 12 opposées perpendiculaires au plan du dessin.
- Le système de filtration 2 est fixé sur une paroi latérale 12 de l'enveloppe, à l'extérieur de l'enveloppe 1.
- Le dispositif de ventilation est positionné en aval du système de filtration 2 par rapport au sens d'injection d'air dans l'enveloppe.

Bien entendu, cet agencement n'est donné qu'à titre d'exemple et tout autre agencement pourrait être prévu, notamment avec l'entrée d'air et la sortie d'air sur les deux autres parois latérales opposées ou en employant la paroi supérieure pour l'entrée ou la sortie d'air.

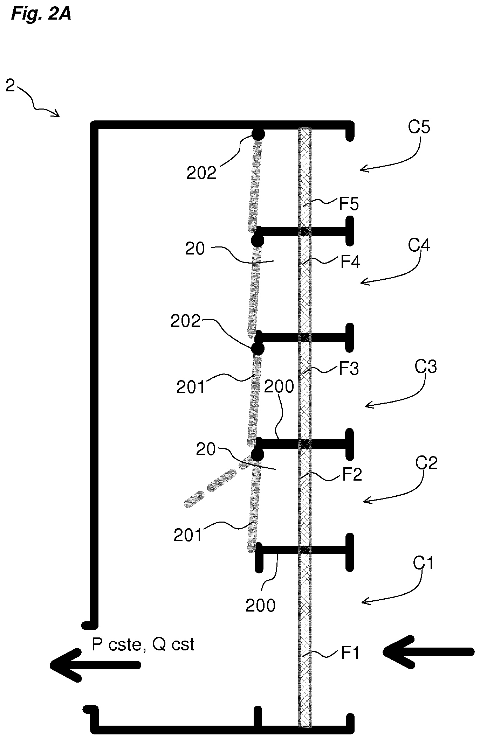

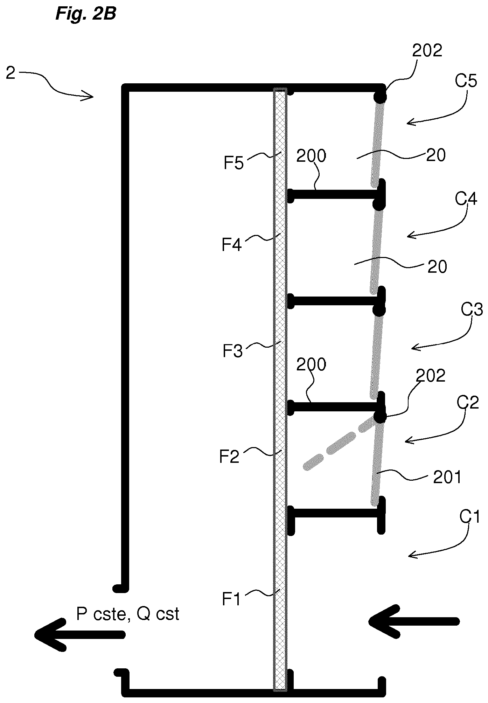

Selon l'invention, en référence aux figures 2A et 2B, le système de filtration 2 comporte plusieurs cellules de filtration Ci indépendantes et séparées l'une de l'autre (avec i allant de 1 à n et n préférentiellement supérieur ou égal à 3). Selon la taille de l'enveloppe, le nombre n de cellules Ci sera par exemple adapté pour ajuster la capacité de refroidissement. Par cellule indépendante, on entend que chaque cellule est cloisonnée par rapport aux autres et est capable d'être traversée par un flux d'air distinct de celui qui traverse chaque autre cellule. Chaque cellule comprendra une entrée d'air débouchant vers l'extérieur et une sortie d'air débouchant vers l'entrée d'air de l'enveloppe électrique. Une chambre pourra être agencée entre l'entrée d'air de l'enveloppe et les sorties d'air des cellules. Comme décrit ci-dessous, l'entrée et/ou la sortie de chaque cellule pourra être initialement fermée par un clapet.

Chaque cellule de filtration Ci comporte un élément de filtration Fi agencé pour filtrer le flux d'air qui traverse la cellule. Chaque élément de filtration pourra être indépendant et amovible ou constituer une zone d'un seul élément de filtration plus grand partagé entre plusieurs cellules de filtration. Comme représenté sur les figures annexées, un seul élément de filtration pourra par exemple être employé pour l'ensemble des cellules de filtration, cet élément de filtration étant partagé en autant de zones de filtration que de cellules de filtrations présentes dans le système. Pour des raisons de simplification, nous parlerons dans la suite de la description de plusieurs éléments Fi de filtration indépendants, associés chacun à une cellule de filtration Ci distincte.

Le système de filtration comporte plus précisément :
- Une cellule de filtration principale C1 qui est active initialement et qui est traversée par tout le flux d'air Q créé grâce au dispositif de ventilation lorsque toutes les autres cellules de filtration sont encore inactives.
- Des cellules de filtration à activation incrémentale, désignées C2 à Cn, qui sont activées de manière incrémentale au fur et à mesure de l'évolution du niveau d'encrassement des éléments de filtration Fi des cellules de filtration déjà activées.

Sur les figures annexées, à titre d'exemple et de manière non limitative, le système de filtration 2 de l'invention est représenté avec cinq cellules de filtration.

Les cellules de filtration C2-Cn à activation incrémentale sont activées de la manière suivante. Pour une cellule Ci inactive, celle-ci devient active lorsque la capacité de filtration des cellules C1 à Ci-1 devient insuffisante, c'est-à-dire lorsque tous les éléments de filtration F1-Fi-1 associés à ces cellules C1 à Ci-1 présentent un niveau d'encrassement global qui dépasse un seuil déterminé. Lorsque ce seuil de niveau d'encrassement global est dépassé, au moins une nouvelle cellule de filtration est activée afin de diviser tout le flux d'air généré grâce au dispositif de ventilation sur un nombre plus important de cellules, augmentant ainsi la surface de filtration du système et permettant de maintenir la capacité de filtration à un niveau suffisant. Tant que le système présente une capacité de filtration suffisante par l'activation incrémentale de cellules de filtration, il ne sera pas forcément nécessaire de remplacer les éléments de filtration. En outre, si le dispositif de ventilation 3 est commandé pour générer un flux d'air Q plus important, la capacité de filtration du système pourra être augmentée en activant plusieurs cellules de filtration simultanément ou à des intervalles de temps plus rapprochés.

En référence aux figures 2A et 2B, une cellule de filtration C2-Cn à activation incrémentale se compose par exemple d'une cavité 20 et est séparée d'une cellule de filtration adjacente par des parois 200. Chaque cellule de filtration à activation incrémentale comporte un clapet 201 qui est apte à se déplacer entre une position fermée et une position ouverte. Lorsque la cellule de filtration est inactive, le clapet 201 est en position fermée et aucune partie du flux d'air ne la traverse. L'élément de filtration associé à la cellule peut être positionné selon deux variantes possibles :
- en amont du clapet par rapport au sens d'injection du flux d'air (figure 2A) , ou
- en aval du clapet par rapport au sens d'injection du flux d'air (figure 2B).

Le montage de l'élément de filtration en amont du clapet permet notamment de protéger ce dernier de la pollution de l'environnement extérieur.

Le montage de l'élément de filtration en aval du clapet permet notamment de limiter les à-coups de débit d'air qui interviennent lors du démarrage du dispositif de ventilation où lors des variations de commande en vitesse du dispositif de ventilation.

Le fonctionnement et les particularités de l'invention seront valables quel que soit l'agencement des éléments de filtration par rapport aux clapets.

Le clapet 201 peut être réalisé en une seule partie ou en plusieurs parties. Il pourra passer d'une position à l'autre, en employant différents mécanismes :
- un mécanisme de pivotement employé pour le faire pivoter autour d'un axe 202 s'il est en une seule partie ou autour de de deux axes parallèles s'il est réalisé en deux parties,
- grâce à un mécanisme de coulissement, des glissières étant prévues pour permettre le coulissement du clapet.

Sur les figures 2A et 2B et de manière non limitative, chaque clapet 201 est monté mobile en pivotement autour d'un axe. Sur ces figures, le clapet de la cellule C2 est représenté, en traits pleins, dans sa position fermée et, en traits pointillés, dans sa position ouverte.

L'activation d'une cellule, par ouverture du clapet, pourra être mise en œuvre selon plusieurs variantes distinctes décrites ci-dessous.

Dans une première variante, le clapet 201 d'une cellule de filtration Ci passe de sa position fermée à sa position ouverte par simple effet mécanique. Lorsque la capacité de filtration des cellules C1 à Ci-1 devient inférieure audit seuil déterminé, la pression de l'air à injecter dans l'enveloppe augmente, générant une force mécanique suffisante pour ouvrir le clapet 201 de la cellule Ci. L'activation incrémentale des cellules sera alors mise en œuvre en calibrant l'ouverture de leurs clapets 201 par rapport à la pression de l'air à injecter dans l'enveloppe grâce au dispositif de ventilation. Le niveau de pression nécessaire pour l'ouverture d'un clapet 201 pourra être réglé de différentes manières. Il pourra s'agir par exemple de lester le clapet de manière adaptée, d'ajuster la surface du clapet ou d'ajuster la taille de la cavité et/ou du conduit d'entrée d'air de la cellule. La solution choisie pourra notamment dépendre du type de dispositif de ventilation employé, celui-ci pouvant générer un débit d'air toujours constant ou, à l'aide d'une électronique de commande, un débit d'air variable.

Dans une deuxième variante de réalisation, l'activation d'une cellule de filtration Ci est commandée par une unité de traitement informatique. Lorsque la capacité de filtration des cellules C1 à Ci-1 devient inférieure audit seuil déterminé et mémorisé dans l'unité de traitement, l'unité de traitement commande l'activation d'une cellule de filtration Ci supplémentaire. Cette commande sera par exemple l'émission d'un signal électrique :
- à destination d'un verrou électromécanique qui, lorsqu'il est activé, déverrouille le clapet 201, l'ouverture du clapet étant alors réalisé par simple gravité ou à l'aide d'un organe mécanique de type ressort ou actionneur, et/ou
- à destination d'un actionneur agencé pour actionner le clapet 201 de sa position fermée à sa position ouverte.

La détermination de la capacité de filtration d'une cellule pourra être réalisée de différentes manières :
- Par mesure du niveau d'encrassement de l'élément de filtration, par tout système de mesure déjà connu. L'unité de traitement compare le niveau d'encrassement mesuré avec un seuil d'encrassement mémorisé.
- Par mesure du débit du flux d'air en sortie de la cellule. Si le débit du flux d'air en sortie d'une cellule devient inférieur à un seuil déterminé mémorisé dans l'unité de traitement, cela signifie que l'élément de filtration ne présente plus une capacité de filtration suffisante.
- Par mesure du temps d'utilisation de l'élément de filtration et comparaison par rapport à une durée normale de fonctionnement efficace obtenue par des données constructeurs ou en mettant en œuvre une période d'apprentissage.
- Par toute autre solution de mesure et/ou de calcul.

Par ailleurs, quelle que soit la variante de réalisation employée pour l'activation de la cellule, le clapet 201 peut être initialement verrouillé dans sa position fermée afin d'éviter toute ouverture intempestive. Le déverrouillage du clapet 201 pourra être commandé par exemple par ladite unité de traitement qui envoie un signal électrique de déverrouillage à un verrou électromécanique lorsque la cellule de filtration correspondante doit être activée.

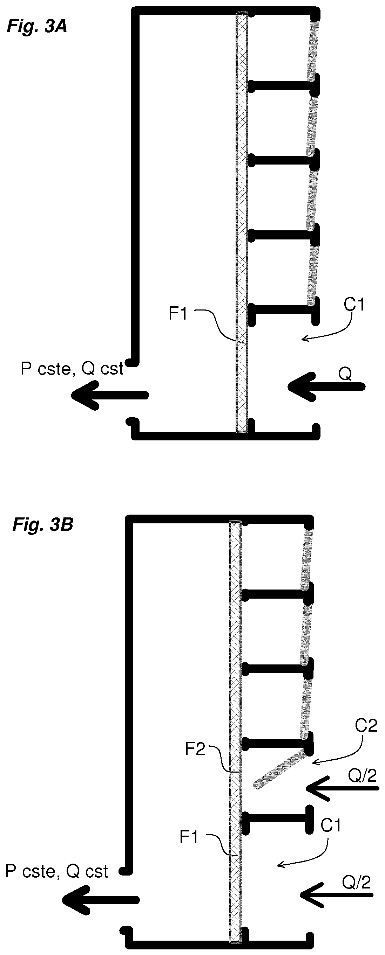

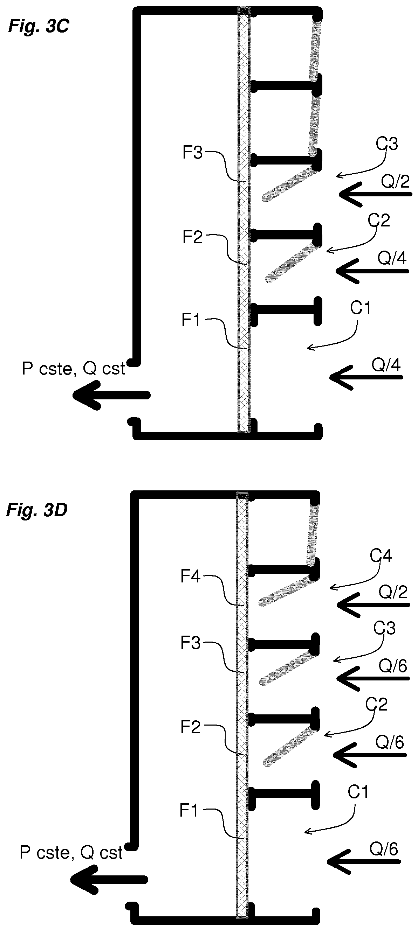

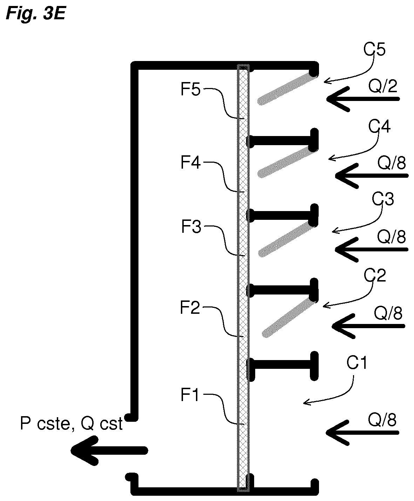

En référence, aux figures 3A à 3E, un système de filtration conforme à l'invention et comprenant par exemple une cellule de filtration principale et quatre cellules de filtration à activation incrémentale, fonctionne comme décrit ci-dessous. Sur ces figures, le fonctionnement est illustré à partir du mode de réalisation de la figure 2B mais il faut comprendre que le principe est le même pour le mode de réalisation de la figure 2A.

**Figure 3A** :
Seule la cellule de filtration C1 principale est active. Tout le flux d'air Q à injecter dans l'enveloppe grâce au dispositif de ventilation est filtré par l'élément de filtration de la cellule de filtration principale C1.

**Figure 3B** :
La capacité de filtration de la cellule de filtration principale C1 est devenue inférieure à une valeur seuil déterminée, entraînant une augmentation de la pression de l'air à travers le système de filtration 2. Lorsque la pression devient supérieure à celle du seuil d'ouverture du clapet de la cellule C2, le clapet de cette cellule C2 s'ouvre. Le seuil d'activation de la cellule est par exemple fixé pour un débit de flux d'air égal à Q/2 à travers la cellule de filtration principale C1. Une fois la cellule C2 active, un flux d'air de débit égal à Q/2 traverse la cellule de filtration principale C1 et un flux d'air de débit égal à Q/2 traverse la cellule de filtration C2.

**Figure 3C** **:**
La capacité de filtration de la cellule de filtration principale et de la cellule de filtration C2 précédemment activée devient insuffisante et inférieure à la valeur seuil déterminée, entraînant de nouveau une augmentation de la pression de l'air à travers le système de filtration 2. Lorsque la pression de l'air devient supérieure à celle du seuil d'ouverture du clapet de la cellule C3, le clapet de cette cellule C3 s'ouvre. Comme précédemment, le seuil d'activation de la cellule est par exemple fixé pour un débit de flux d'air égal à Q/2 pour l'ensemble formé de la cellule de filtration principale C1 et de la cellule de filtration C2. Une fois la cellule C3 active, un flux d'air de débit égal à Q/4 traverse la cellule de filtration principale C1, un flux d'air de débit égal à Q/4 traverse la cellule de filtration C2, un flux d'air de débit égal à Q/2 traverse la cellule de filtration C3.

**Figure 3D** :
La capacité de filtration de la cellule de filtration principale, de la cellule de filtration C2 et de la cellule de filtration C3 précédemment activées devient insuffisante et inférieure à la valeur seuil déterminée, entraînant de nouveau une augmentation de la pression de l'air à travers le système de filtration 2. Lorsque la pression de l'air devient supérieure à celle du seuil d'ouverture du clapet de la cellule C4, le clapet de cette cellule C4 s'ouvre. Comme précédemment, le seuil d'activation de la cellule C4 est par exemple fixé pour un flux d'air de débit égal à Q/2 pour l'ensemble formé de la cellule de filtration principale, de la cellule de filtration C2 et de la cellule de filtration C3. Une fois la cellule C4 active, un flux d'air de débit égal à Q/6 traverse la cellule de filtration principale C1, un flux d'air de débit égal à Q/6 traverse la cellule de filtration C2, un flux d'air de débit égal à Q/6 traverse la cellule de filtration C3 et un flux d'air de débit égal à Q/2 traverse la cellule de filtration C4.

**Figure 3E** **:**
La capacité de filtration de la cellule de filtration principale, de la cellule de filtration C2, de la cellule de filtration C3 et de la cellule de filtration C4 précédemment activées devient insuffisante et inférieure à la valeur seuil déterminée, entraînant de nouveau une augmentation de la pression de l'air en amont du système de filtration. Lorsque la pression de l'air devient supérieure à celle du seuil d'ouverture du clapet de la cellule C5, le clapet de cette cellule C5 s'ouvre. Comme précédemment, le seuil d'activation de la cellule C5 est par exemple fixé pour un flux d'air de débit égal à Q/2 pour l'ensemble formé de la cellule de filtration principale, de la cellule de filtration C2, de la cellule de filtration C3 et de la cellule de filtration C4. Une fois la cellule C5 active, un flux d'air de débit égal à Q/8 traverse la cellule de filtration principale, un flux d'air de débit égal à Q/8 traverse la cellule de filtration C2, un flux d'air de débit égal à Q/8 traverse la cellule de filtration C3, un flux d'air de débit égal à Q/8 traverse la cellule de filtration C4 et un flux d'air de débit égal à Q/2 traverse la cellule de filtration C5.

Lorsque l'ensemble formé par toutes les cellules du système présente une capacité de filtration inférieure à un seuil déterminé, par exemple correspondant à un flux d'air de débit inférieur à Q/2, il sera nécessaire de remplacer les éléments de filtration.

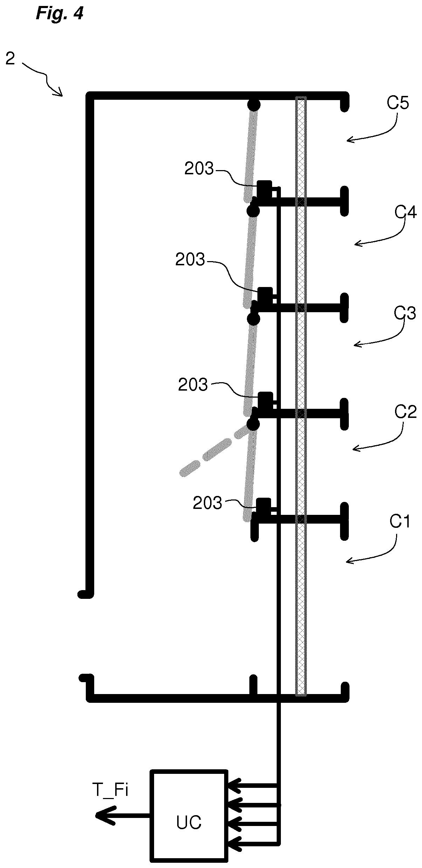

Selon une variante de réalisation de l'invention représentée sur la figure 4, le système de filtration 2 comporte un capteur 203 associé à chaque cellule de filtration C2-Cn à activation incrémentale, pour détecter l'instant d'activation de la cellule. Le système 2 comporte par ailleurs une unité de traitement UC comportant plusieurs entrées, associées chacune à un capteur 203 distinct pour prélever l'état de chaque capteur. L'unité de traitement comporte un module de calcul agencé pour déterminer le moment de remplacement T_Fi de chaque élément de filtration Fi à partir de la durée s'écoulant entre deux activations de cellules successives.

## Revendications

1. Enveloppe électrique (1) destinée à loger des appareils électriques et comportant une entrée d'air (4), une sortie d'air (5), un dispositif de ventilation (3) agencé pour favoriser l'injection d'air par l'entrée d'air de l'enveloppe, et un système de filtration (2) positionné au niveau de l'entrée d'air, en amont du dispositif de ventilation (3) par rapport au sens d'injection d'air dans l'enveloppe, **caractérisée en ce que** le système de filtration (2) comporte :
plusieurs cellules de filtration Ci indépendantes, avec i allant de 1 à n, avec n supérieur ou égal à 2, chaque cellule de filtration Ci présentant une capacité de filtration variable au cours du temps, la ou les cellules Ci avec i supérieur ou égal à 2 étant configurées pour être individuellement et successivement déplacées d'un état désactivé vers un état activé pour filtrer une partie de l'écoulement d'air lorsque la somme des capacités de filtration des cellules de filtration qui sont déjà activées tombent en dessous d'un seuil prédéterminé,
une cellule de filtration principale C1 qui est active initialement et qui est traversé par tout le flux d'air créé grâce au dispositif de ventilation lorsque toutes les autres cellules de filtration sont encore inactives,
chaque cellule de filtration Ci avec i supérieur ou égal à 2 comportant un clapet 201 qui est apte à se déplacer entre une position fermée lorsque la cellule de filtration est inactive et aucune partie du flux d'air ne la traverse, et une position ouverte lorsque la cellule de filtration est active et qu'une partie du flux d'air la traverse,
le système de filtration comportant en outre :
des moyens de mesure de la capacité de filtration des cellules,
des moyens de commande aptes à entraîner l'activation d'une cellule supplémentaire de filtration lorsque la somme précitée des capacités de filtration devient inférieure audit seuil déterminé, chaque cellule de filtration Ci, avec i supérieur ou égal à 2, étant rendue active par ouverture du clapet précité, pour filtrer une partie du flux d'air, et
**en ce que** Q étant tout le flux d'air crée grâce au dispositif de ventilation lorsque toutes les autres cellules de filtration sont encore inactives, le seuil déterminé précité est Q/2, et **en ce qu'**après la commande, c'est Q/2 qui s'écoule à travers le filtre nouvellement activé.

2. Enveloppe électrique selon la revendication 1, **caractérisée en ce que** chaque cellule de filtration Ci avec i supérieur ou égal à 2, est agencée pour être activée par effet mécanique lorsque le flux d'air en entrée présente une pression qui devient supérieure à une valeur déterminée, ladite valeur déterminée étant dépendante dudit seuil de capacité de filtration des cellules C1 à Ci-1.

3. Enveloppe électrique selon la revendication 1 ou 2, **caractérisée en ce que** chaque cellule de filtration Ci avec i supérieur ou égal à 2 comporte un clapet (201) mobile entre une position ouverte et une position fermée, ledit clapet étant calibré pour se déplacer vers sa position ouverte lorsque la pression du flux d'air en entrée devient supérieure à ladite valeur déterminée.

4. Enveloppe électrique selon la revendication 3, **caractérisée en ce que** le clapet (201) est monté mobile en pivotement autour d'un axe (202).

5. Enveloppe électrique selon la revendication 3 ou 4, **caractérisée en ce que** chaque cellule comporte un verrou agencé pour verrouiller le clapet (201) en position fermée.

6. Enveloppe électrique selon l'une des revendications 3 à 5, **caractérisée en ce que**, dans chaque cellule, l'élément de filtration (Fi) est logé dans la cellule, en amont du clapet.

7. Enveloppe électrique selon l'une des revendications 3 à 5, **caractérisée en ce que**, dans chaque cellule, l'élément de filtration (Fi) est positionné en aval du clapet.

8. Enveloppe électrique selon l'une des revendications 1 à 7, **caractérisée en ce que** chaque cellule de filtration comporte un capteur (203) agencé pour prendre un premier état correspondant à l'état désactivé de la cellule de filtration ou un deuxième état correspondant à l'état activé de la cellule.

9. Enveloppe électrique selon la revendication 8, **caractérisée en ce qu'**il comporte une unité de traitement (UC) connectée à chaque capteur (203) et agencée pour récupérer l'état de chaque capteur.

10. Enveloppe électrique selon la revendication 9, **caractérisée en ce que** l'unité de traitement (UC) comporte un module de calcul agencé pour calculer une durée
s'écoulant entre deux activations successives de deux cellules de filtration 1.

11. Enveloppe électrique selon la revendication 10, **caractérisée en ce que** l'unité de traitement (UC) comporte un module de prédiction du moment de remplacement de l'élément de filtration à partir de la durée calculée par le module de calcul.

## Patentansprüche

1. Elektrisches Gehäuse (1), das dazu bestimmt ist, elektrische Geräte aufzunehmen, und einen Lufteinlass (4), einen Luftauslass (5), eine Lüftungsvorrichtung (3), die dazu ausgebildet ist, das Einblasen von Luft durch den Lufteinlass des Gehäuses zu begünstigen, und ein Filtersystem (2), das an dem Lufteinlass stromauf der Lüftungsvorrichtung (3) in Bezug auf die Lufteinblasrichtung in das Gehäuse angeordnet ist, umfasst, **dadurch gekennzeichnet, dass** das Filtersystem (2) umfasst:
mehrere unabhängige Filterzellen Ci, wobei i von 1 bis n reicht, wobei n größer oder gleich 2 ist, wobei jede Filterzelle Ci eine im Laufe der Zeit veränderliche Filterkapazität aufweist, wobei die Zelle oder Zellen Ci mit i größer oder gleich 2 dazu ausgestaltet ist bzw. sind, einzeln und nacheinander aus einem deaktivierten Zustand in einen aktivierten Zustand verlagert zu werden, um einen Teil des Luftstroms zu filtern, wenn die Summe der Filterkapazitäten der Filterzellen, die bereits aktiviert sind, unter einen vorbestimmten Schwellenwert fällt,
eine Hauptfilterzelle C1, die anfänglich aktiv ist und die von dem gesamten Luftstrom durchquert wird, der mithilfe der Lüftungsvorrichtung erzeugt wird, wenn alle anderen Filterzellen noch inaktiv sind,
wobei jede Filterzelle Ci mit i größer oder gleich 2 eine Klappe 201 umfasst, die geeignet ist, sich zwischen einer geschlossenen Stellung, wenn die Filterzelle inaktiv ist und kein Teil des Luftstroms sie durchquert, und einer geöffneten Stellung, wenn die Filterzelle aktiv ist und ein Teil des Luftstroms sie durchquert, zu verlagern,
wobei das Filtersystem ferner umfasst:
Mittel zum Messen der Filterkapazität der Zellen,
Steuermittel, die geeignet sind, die Aktivierung einer zusätzlichen Filterzelle zu bewirken, wenn die vorgenannte Summe der Filterkapazitäten geringer als der bestimmte Schwellenwert wird, wobei jede Filterzelle Ci, mit i größer oder gleich 2, durch Öffnen der vorgenannten Klappe aktiv gemacht wird, um einen Teil des Luftstroms zu filtern, und
dass, wenn Q der gesamte Luftstrom ist, der mithilfe der Lüftungsvorrichtung erzeugt wird, wenn alle anderen Filterzellen noch inaktiv sind, der vorgenannte bestimmte Schwellenwert Q/2 ist, und dass nach der Steuerung Q/2 durch den neu aktivierten Filter strömt.

2. Elektrisches Gehäuse nach Anspruch 1, **dadurch gekennzeichnet, dass** jede Filterzelle Ci mit i größer oder gleich 2 dazu ausgebildet ist, durch mechanische Wirkung aktiviert zu werden, wenn der Luftstrom im Einlass einen Druck aufweist, der größer als ein bestimmter Wert wird, wobei der bestimmte Wert von dem Schwellenwert der Filterkapazität der Zellen C1 bis Ci-1 abhängig ist.

3. Elektrisches Gehäuse nach Anspruch 1 oder 2, **dadurch gekennzeichnet, dass** jede Filterzelle Ci mit i größer oder gleich 2 eine Klappe (201) umfasst, die zwischen einer geöffneten Stellung und einer geschlossenen Stellung beweglich ist, wobei die Klappe dazu kalibriert ist, sich in ihre geöffnete Stellung zu verlagern, wenn der Druck des Luftstroms im Einlass größer als der bestimmte Wert wird.

4. Elektrisches Gehäuse nach Anspruch 3, **dadurch gekennzeichnet, dass** die Klappe (201) um eine Achse (202) schwenkend beweglich gelagert ist.

5. Elektrisches Gehäuse nach Anspruch 3 oder 4, **dadurch gekennzeichnet, dass** jede Zelle eine Verriegelung umfasst, die dazu ausgebildet ist, die Klappe (201) in der geschlossenen Stellung zu verriegeln.

6. Elektrisches Gehäuse nach einem der Ansprüche 3 bis 5, **dadurch gekennzeichnet, dass** in jeder Zelle das Filterelement (Fi) in der Zelle stromauf der Klappe aufgenommen ist.

7. Elektrisches Gehäuse nach einem der Ansprüche 3 bis 5, **dadurch gekennzeichnet, dass** in jeder Zelle das Filterelement (Fi) stromab der Klappe angeordnet ist.

8. Elektrisches Gehäuse nach einem der Ansprüche 1 bis 7, **dadurch gekennzeichnet, dass** jede Filterzelle einen Sensor (203) umfasst, der dazu ausgebildet ist, einen dem deaktivierten Zustand der Filterzelle entsprechenden ersten Zustand oder einen dem aktivierten Zustand der Zelle entsprechenden zweiten Zustand anzunehmen.

9. Elektrisches Gehäuse nach Anspruch 8, **dadurch gekennzeichnet, dass** es eine Verarbeitungseinheit (UC) umfasst, die an jeden Sensor (203) angeschlossen ist und dazu ausgebildet ist, den Zustand jedes Sensors zu erfassen.

10. Elektrisches Gehäuse nach Anspruch 9, **dadurch gekennzeichnet, dass** die Verarbeitungseinheit (UC) ein Rechenmodul umfasst, das dazu ausgebildet ist, eine Dauer zu berechnen, die zwischen zwei aufeinander folgenden Aktivierungen von zwei Filterzellen 1 vergeht.

11. Elektrisches Gehäuse nach Anspruch 10, **dadurch gekennzeichnet, dass** die Verarbeitungseinheit (UC) ein Modul zum Vorhersagen des Austauschzeitpunkts des Filterelements ausgehend von der von dem Rechenmodul berechneten Dauer umfasst.

## Claims

1. Electrical enclosure (1) intended to house electrical devices and having an air inlet (4), an air outlet (5), a fan device (3) arranged to favour the injection of air through the air inlet of the enclosure, and a filtering system (2) positioned at the air inlet, upstream from the fan device (3) relative to the direction of air injection into the enclosure, **characterized in that** the filtering system (2) comprises:
several independent filtering cells Ci, with i ranging from 1 to n, and with n greater than or equal to 2, each filtering cell Ci having a filtering capacity that is variable over time, the cell or cells Ci with i greater than or equal to 2 being configured to be individually and successively moved from a deactivated state to an activated state to filter a part of the air flow when the sum of the filtering capacities of the filtering cells which have already been activated drops below a predetermined threshold,
a main filtering cell C1 which is initially active and through which passes the entire air flow created by the fan device when all the other filtering cells are still inactive,
each filtering cell Ci with i greater than or equal to 2 having a valve 201 which is capable of moving between a closed position when the filtering cell is inactive and no part of the air flow passes through it, and an open position when the filtering cell is active and a part of the air flow passes through it,
the filtering system further comprising:
means for measuring the filtering capacity of the cells,
control means capable of causing the activation of an additional filtering cell when the aforementioned sum of the filtering capacities becomes less than said specific threshold, each filtering cell Ci, with i greater than or equal to 2, being rendered active by opening of the aforementioned valve, to filter a part of the air flow, and
**in that** Q being the entire air flow created by the fan device when all the other filtering cells are still inactive, the aforementioned specific threshold is Q/2, and **in that** after the control, it is Q/2 that flows through the newly activated filter.

2. Electrical enclosure according to Claim 1, **characterized in that** each filtering cell Ci with i greater than or equal to 2 is arranged to be mechanically activated when the inlet air flow has a pressure that exceeds a specific value, said specific value being dependent on said filtering capacity threshold of the cells C1 to Ci-1.

3. Electrical enclosure according to Claim 1 or 2, **characterized in that** each filtering cell Ci with i greater than or equal to 2 has a valve (201) movable between an open position and a closed position, said valve being calibrated to move to its open position when the pressure of the inlet air flow becomes greater than said specific value.

4. Electrical enclosure according to Claim 3, **characterized in that** the valve (201) is mounted pivotably movable about an axis (202).

5. Electrical enclosure according to Claim 3 or 4, **characterized in that** each cell comprises a lock arranged to lock the valve (201) in the closed position.

6. Electrical enclosure according to one of Claims 3 to 5, **characterized in that**, in each cell, the filtering element (Fi) is housed in the cell, upstream from the valve.

7. Electrical enclosure according to one of Claims 3 to 5, **characterized in that**, in each cell, the filtering element (Fi) is positioned downstream from the valve.

8. Electrical enclosure according to one of Claims 1 to 7, **characterized in that** each filtering cell includes a sensor (203) arranged to assume a first state corresponding to the deactivated state of the filtering cell or a second state corresponding to the activated state of the cell.

9. Electrical enclosure according to Claim 8, **characterized in that** it comprises a processing unit (CPU) connected to each sensor (203) and arranged to retrieve the status of each sensor.

10. Electrical enclosure according to Claim 9, **characterized in that** the processing unit (CPU) includes a calculation module arranged to calculate a duration between two successive activations of two filtering cells 1.

11. Electrical enclosure according to Claim 10, **characterized in that** the processing unit (CPU) includes a module for predicting the replacement time of the filtering element based on the duration calculated by the calculation module.
